**Europäisches Patentamt**

**European Patent Office**

**Office européen des brevets**

(19)

(11) Veröffentlichungsnummer: **0 264 364**
**B1**

(12) **EUROPÄISCHE PATENTSCHRIFT**

(45) Veröffentlichungstag der Patentschrift: **30.05.90**

(21) Anmeldenummer: **86901803.6**

(22) Anmeldetag: **14.03.86**

(86) Internationale Anmeldenummer:
**PCT/DE86/00110**

(87) Internationale Veröffentlichungsnummer:
**WO 87/01007 12.02.87 Gazette 87/04**

(51) Int. Cl.⁵: **H 05 K 7/20, H 05 K 9/00**

(54) **ELEKTRISCHES SCHALTGERÄT.**

(30) Priorität: **30.07.85 DE 3527208**

(43) Veröffentlichungstag der Anmeldung:
**27.04.88 Patentblatt 88/17**

(45) Bekanntmachung des Hinweises auf die
Patenterteilung:
**30.05.90 Patentblatt 90/22**

(84) Benannte Vertragsstaaten:
**DE FR GB IT SE**

(56) Entgegenhaltungen:
**DE-A-2 823 699**
**DE-U-7 909 986**
**FR-A-2 366 685**
**GB-A-2 027 290**
**US-A-4 060 847**
**US-A-4 196 467**

**Die Akte enthält technische Angaben, die nach
dem Eingang der Anmeldung eingereicht
wurden und die nicht in dieser Patentschrift
enthalten sind.**

(73) Patentinhaber: **ROBERT BOSCH GMBH**
**Postfach 50**
**D-7000 Stuttgart 1 (DE)**

(72) Erfinder: **FASSEL, Reinhard**
**Hebelstrasse 9**
**D-8507 Oberasbach (DE)**
Erfinder: **HAUBNER, Georg**
**Ludwigstrasse 1**
**D-8438 Berg (DE)**
Erfinder: **ZÖBL, Hartmut**
**Moststrasse 25**
**D-8510 Fürth/Bay. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung geht aus von einem elektrischen Schaltgerät nach der Gattung des Hauptanspruchs.

Es ist bekannt, bei wasserdichten elektronischen Geräten die Wärme, welche in den darin angeordneten Leistungsbauelementen erzeugt wird, über Kühlbleche nach außen zu führen, wobei die Kühlbleche gleichzeitig zur Befestigung des Schaltgerätes verwendet werden (DE-GM 79 09 986). Bei elektrischen Geräten mit einem vollisolierten Gehäuse ist es bekannt, die Wärme von Leistungstransistoren und Leistungswiderständen über ein Kühlblech direkt auf einen Anschlußstecker zu führen, bzw. Kühlblech und Anschlußstecker als ein Bauteil auszubilden, über das die Wärme nach außen geführt und über den angeschlossenen Kabelbaum mit seiner guten Wärmeleitung und seiner großen Oberfläche abgeleitet wird. Diese Lösung hat sich besonders im Motorraum von Kraftfahrzeugen bei Reglerschaltern und Blinkgebern bewährt.

Da derartige Schaltgeräte in Kraftfahrzeugen in letzter Zeit umfangreicher, die Anschlußstecker kleiner und deren zu Steckereinheiten zusammengefaßte Anzahl jedoch größer geworden sind, ist die Abführung der an den Leistungsbauelementen solcher Schaltgeräte erzeugten Wärme über die ihnen jeweils zugeordneten Stecker allein nicht mehr möglich.

Aus der US-A- 40 60 847 ist ein elektrisches Schaltgerät bekannt, bei dem die im inneren des Schaltgerätes entstehende Wärme von den elektrischen Leitern innerhalb des Gerätes aufgenommen und durch die aus Isolierstoff hergestellte Bodenplatte des Schaltgerätes nach außen abgeführt. Ein Kühlkörper an der Unterseite der Bodenplatte des Schaltgerätes ist wärmeleitend und elektrisch isoliert mit den Anschlußleitern des Schaltgerätes flächig verbunden, so daß die Wärme über die Leiter auf den Kühlkörper übertragen und von dort durch Konvektion nach außen abgeführt werden kann. Auch bei dieser Lösung ist die Abführung größerer Wärmemengen, die von einem oder mehreren leistungsstarken Bauelementen erzeugt wird über die jeweils ihnen zugeordnete Stecker allein nicht mehr möglich.

Außerdem ist es insbesondere bei elektrischen Geräten mit elektronischen Bauteilen erwünscht, die elektronischen Bauteile gegen HF-Schwingungen zu schützen, die von außen über die Anschlußleitungen in das Schaltgerät gelangen können.

Mit der vorliegenden Lösung wird angestrebt, die Abführung der in den Leistungsbauelementen elektrisch erzeugten Wärme über die Anschlußteile des Schaltgerätes mit Mitteln zu verbessern, die zugleich eine Abschirmung gegen HF-Störungen bewirken.

**Vorteile der Erfindung**

Das erfindungsgemäße elektrische Schaltgerät mit den kennzeichnenden Merkmalen des Hauptanspruchs hat den Vorteil, daß die in einem oder mehreren Leistungsbauelementen erzeugte elektrische Wärme gleichmäßig über mehrere bzw. über alle Anschlußteile nach außen geführt wird, so daß ein zur Zerstörung der Bauelemente führender Wärmestau im Schaltgerät vermieden wird. Als weiterer Vorteil ist anzusehen, daß mehrere Leistungsbauelemente über einzelne, ihnen zugeordnete Kühlkörper in Form von Kühlblechen jeweils mit der zur ausreichenden Wärmeabführung erforderlichen Anzahl von Anschlußteilen, beispielsweise in Form von Flachsteckzungen wärmeleitend verbunden werden. Das Umgeben von Anschlußteilen mit einem HF-abschirmenden und zugleich wärmeleitenden, elektrisch isolierenden Material verhindert zusätzlich das Eindringen von HF-Störungen über die Anschlußleitungen in das Schaltgerät.

Durch die in den Unteransprüchen aufgeführten Maßnahmen sind vorteilhafte Weiterbildungen und Verbesserungen der im Haputanspruch angegebenen Merkmale möglich. Besonders vorteilhaft ist, den Kühlkörper über einen dünne Isolierfolie und eine Wärmeleitpaste mit den Anschlußteilen zu verbinden. Um bei Schaltgeräten mit mehreren Leistungsbauelementen die Anzahl der Kühlkörper einzuschränken, ist es vorteilhaft, auf einem Kühlkörper mehrere Leistungsbauelemente anzuordnen, wobei gegenenfalls zur Vermeidung von Kurzschlüssen die Leistungsbauelementen auf den Kühlkörpern elekrisch isoliert und wärmeleitend befestigt sind.

**Zeichnung**

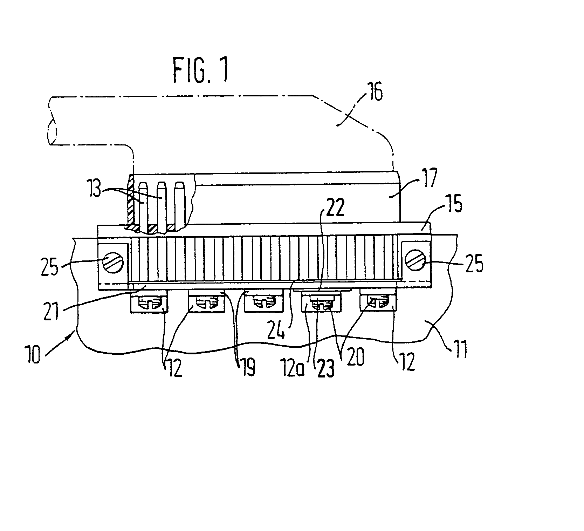

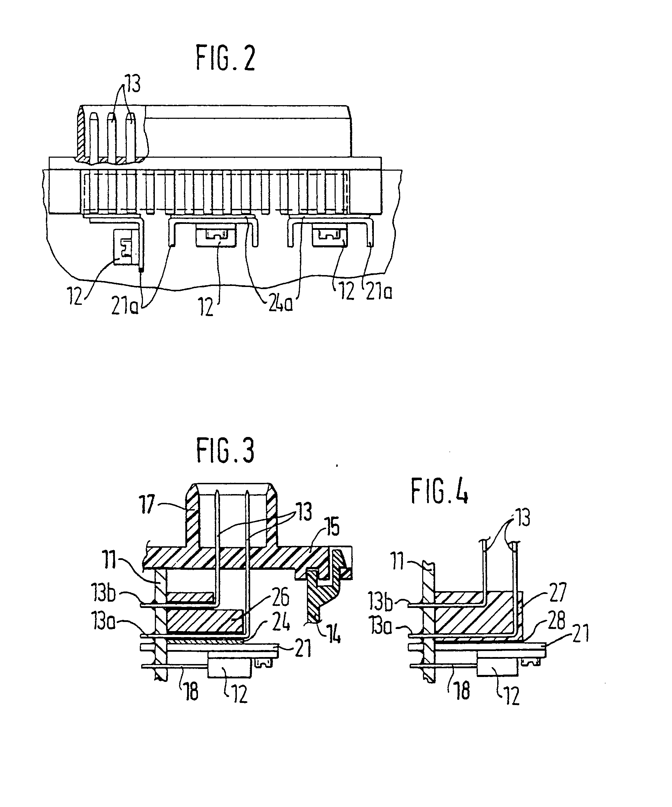

Einige Ausführungsbeispiele der Erfindung sind in der Zeichnung dargestellt und in der nachfolgenden Beschreibung näher erläutert. Es zeigen Figur 1 den Anschlußbereich eines elektrischen Gerätes mit einem Vielpol-Steckanschluß mit mehreren Leistungsbauelementen und einem Kühlkörper, Figur 2 ein weiteres Ausführungsbeispiel der Erfindung mit mehreren Leistungsbauelementen und mehreren Kühlblechen, Figur 3 einen Längsschnitt durch den Anschlußbereich des Schaltgeräts nach Figur 1 oder 2 in der Seitenansicht, Figur 4 zeigt ein weiteres Ausführungbeispiel der Erfindung mit in wärmeleitendem Material eingebetteten Anschlußteilen.

**Beschreibung der Ausführungsbeispiele**

In Figur 1 sind Einzelheiten des oberen Anschlußbereiches eines elektronischen Schalt- und Steuergerätes 10 für ein Kraftfahrzeug dargestellt. Eine Leiterplatte 11 mit mehreren Halbleiter-Leistungsbauelementen 12 und einer Vielzahl von Flachsteckzungen 13 als Anschlußteile des Gerätes 10 sind in eine Öffnung des vollisolierten Gehäuses 14 aus Kunststoff (Fig. 3) mit einer die Flachsteckzungen 13 fixierenden Anschlußplatte 15 wasserdicht eingesetzt. Die Flachsteckzungen 13 sind zur Aufnahme eines strichpunktiert angedeuteten mehrpoligen Kabelanschlusses 16 von einem Kragen 17 umgeben, der an der Anschlußplatte 15 angeformt ist. Die Leistungsbauelemente 12 sind über Anschlüsse 18 mit den Leiterbahnen der Leiterplatte 11 kontaktiert und mit ihrer Fußplatte 19 durch Schrauben 20 auf einem Kühlblech 21 aus Stahl oder Kupfer festgeschraubt. Falls erforderlich, kann das Leistungsbauelement 12a auf dem Kühlblech 21 auch elektrisch isoliert befestigt werden, indem zwischen seiner Fußplatte 19 und dem Kühlblech 21 eine dünne Isolierfolie 22 gelegt wird und die im Kühlblech 21 eingedrehte Schraube 20 durch eine Isolierstoffbuchse 23 gegen die Fußplatte 19 isoliert wird.

Zur Abführung der Wärme, die in den Leistungsbauelementen 12, 12a erzeugt wird und die aus dem Gerät 10 herausgeführt werden muß, ist das Kühlblech 21 wärmeleitend und elektrisch isoliert mit mehreren Flachsteckzungen 13 flächig verbunden. Wie Figure 3 zeigt, sind die Flachsteckzungen 13 in zwei mit Abstand nebeneinanderliegenden Reihen angeordnet. Die vordere Reihe der Flachsteckzungen 13 liegt dabei mit ihren zur Leiterplatte 11 hin abgewinkelten Endbereichen 13a unmittelbar oberhalb des Kühlblechs 21. Aus Figur 3 ist erkennbar, daß zwischen dem Kühlblech 21 und den Endbereichen 13a der Flachsteckzungen 13 eine dünne Isolierfolie 24 aus Kunststoff angeordnet ist. Die Isolierfolie 24 ist beidseitig mit einer kupferoder silberhaltige Wärmeleitpaste z.B. eingestrichen, so daß sie eine flächige Verbindung zwischen dem Kühlblech 21 und den Flachsteckzungen 13 bildet, die einerseits elektrisch isolierend und andererseits wärmeleitend wirkt. In gleicher Weise kann auch die Isolierfolie 22 zwischen dem Leistungsbauelement 12a und dem Kühlblech 21 mit der Wärmeleitpaste eingestrichen werden, um die elektrische Isolation einerseits und die Wärmeleitung andererseits zu gewährleisten. Außerdem wurde Warmeleitpaste im Bereich der Abbiegung der Flachsteckzungen 13 aufgetragen. Das Kühlblech 21 wird einerseits von der Leiterplatte 11 gehalten und gegebenenfalls kontaktiert sowie andererseits mittels Schrauben 25 an einem Ansatz der Anschlußplatte 15 angeschraubt.

Die Figur 2 zeigt ein weitere Ausführungsbeispiel der Erfindung, bei der anstelle eines gemeinsamen Kühlbleches für alle Leistungsbauelemente drei Leistungsbauelemente 12 mit drei ihnen zugeordneten Kühlblechen 21a versehen sind. Auch hier sind die Kühlbleche 21a über dünne Isolierfolien 24a mit mehreren Flachsteckzungen 13 elektrisch isoliert und wärmeleitend in ihrem abgewinkelten Bereich 13a flächig verbunden.

Figur 3 zeigt eine Lösung, bei der die Wärmeabführung von den Leistungsbauelementen 12 über sämtliche Flachsteckzungen 13 des Gerätes 10 erfolgt. Um die Wärme von der linken Reihe der Flachsteckzungen auch auf die rechte Reihe der Flachsteckzungen 13 zu übertragen, ist zwischen den abgewinkelten Endbereichen der beiden Reihen von Flachsteckzungen 13 ein wärmeleitender, elektrisch isolierender Körper 26 angeordnet, der aus einer Aluminiumoxidkeramik, einer Ferritoxidkeramik bzw. aus einem mit Ferrit gefüllten Kunststoff bestehen kann. Die zwischen dem Kühlblech 21 und den unteren Endabschnitten 13a der Flachsteckzungen 13 angeordnete Isolierfolie 24 kann ebenfalls eine Metalloxidkeramik bzw. eine mit Ferrit versetzte Kunststoffolie sein. Bei dieser Ausführung gelangt die in den Leistungsbauelementen 12 erzeugte Wärme über das Kühlblech 21 und die Isolierfolie 24 zunächst auf die unteren Endbereiche 13a der Flachsteckzungen 13. Ein Teil der Wärme wird von dort über die Flachsteckzungen 13 der rechten Reihe nach außen abgeführt, während die restliche Wärme über den wärmeleitenden, elektrisch isolierenden Körper 26 zu den davon eingefaßten darüber liegenden, benachbarten Endbereichen 13b der linken Reihe von Flachsteckzungen 13 gelangt und über diese Flachsteckzungen 13 nach außen abgeführt wird.

Ein weiteres Ausführungsbeispiel der Erfindung ist in Figur 4 dargestellt, wonach die Flachsteckzungen 13 mit ihren abgewinkelten Endbereichen 13a, 13b im Bereich des Kühlbleches 21 in einem wärmeleitenden, elektrisch isolierenden Material 27 vollständig eingebettet sind. Das Material 27 kann ebenfalls eine Metalloxidkeramik oder ein mit Ferrit gefüllter Kunststoff sein. Eine großflächige Verbindung zwischen dem darunter angeordneten Kühlblech 21 mit den Leistungsbauelementen 12 einerseits und dem Material 27 wird wiederum mit einer Wärmeleitpaste 28 erreicht, die vor der Montage an den entsprechenden Flächen von Kühlblech 21 und/oder Material 27 aufgetragen wird.

Die Einbettung bzw. das Einfassen der Endbereiche 13a und 13b der Flachsteckzungen 13 in eine Metalloxidkeramik bzw. in einen mit Ferrit gefüllten Kunststoff bewirkt zusätzlich eine Abschirmung des Gerätes 10 gegen das Eindringen von HF-Störungen, welche über die Anschlußleitungen zu den Flachsteckzungen 13 des Gerätes 10 gelangen können. Um auch bei den Ausführungen nach Figur 1 bis 3 eine gute Abschirmung gegen HF-Störungen zu erzielen, können die Kühlbleche 21, 21a gegebenenfalls so geformt sein, daß sie den unterhalb der Anschlußplatte 15 liegenden Bereich der Flachsteckzungen 13 umfassen. Durch diese Maßnahme wird sowohl die Abschirmung gegen HF-Störungen als auch die Wärmeabführung von den Leistungsbauelementen 12 noch verbessert.

**Patentansprüche**

1. Elektrisches Schaltgerät (10) mit mindestens einem in einem vollisolierten Gehäuse (14) angeordneten Leistungsbauelement (12, 12a), einem Kühlkörper (21, 21a) zur Wärmeabführung sowie mit aus dem Gehäuse (14) herausgeführten, voneinander elektrisch isolierten Anschlußteilen (13), dadurch gekennzeichnet, daß das mindestens ein Leistungsbauelement (12, 12a) auf dem Kühlkörper (21, 21a) angeordnet ist und daß im Bereich des Kühlkörpers (21, 21a) mehrere Anschlußteile (13) von einem HF abschirmenden und zugleich wärmeleitenden, elektrisch isolierenden Material (26, 27) umgeben sind, mit dem der Kühlkörper (21, 21a) flächig verbunden ist, um die Wärme des mindestens einen Leistungsbauelementes (12, 12a) über den Kühlkörper (21, 21a) auf die Anschlußteile 13 und von dort nach außen abzuführen.

2. Schaltgerät nach Anspruch 1, dadurch gekennzeichnet, daß auf dem Kühlkörper (21) mehrere Leistungsbauelemente (12, 12a) angeordnet sind.

3. Schaltgerät nach einem der vorherigen Ansprüche, dadurch gekennzeichnet, daß mindestens ein Leistungsbauelement (12a) auf dem Kühlkörper (21) elektrisch isoliert und wärmeleitend befestigt ist.

4. Schaltgerät nach einem der vorherigen Ansprüche, dadurch gekennzeichnet, daß zwischen benachbarten Anschlußteilen (13) ein HF abschirmender sowie wärmeleitender, elektrisch isolierender Körper (26, 27) angeordnet ist.

5. Schaltgerät nach Anspruch 4, dadurch gekennzeichnet, daß der Körper (26, 27) aus einem mit Ferrit gefüllten Kunststoff bzw. aus einer Metalloxid-Keramik besteht.

6. Schaltgerät nach einem der vorherigen Ansprüche, dadurch gekennzeichnet, daß der Kühlkörper (21, 21a) über eine dünne Isolierfolie (24) und eine Wärmeleitpaste mit den Anschlußteilen (13) verbunden ist.

7. Schaltgerät nach Anspruch 6, dadurch gekennzeichnet, daß die Isolierfolie (24) aus einer Metalloxid-Keramik bzw. aus einem mit Ferrit gefüllten Kunststoff besteht.

8. Schaltgerät nach einem der vorherigen Ansprüche, dadurch gekennzeichnet, daß der Kühlkörper (21, 21a) zur HF-Abschirmung die Anschlußteile (13) teilweise umfaßt.

**Revendications**

1. Contacteur électrique (10) avec au moins un composant de puissance (12, 12a) disposé dans un boîtier entièrement isolé (14), un refroidisseur (21, 21a) pour évacuer la chaleur, ainsi que des pièces de connexion (13) isolées électriquement l'une de l'autre, sortant du boîtier (14), caractérisé en ce qu'au moins un composant de puissance (12, 12a) est disposé sur le refroidisseur (21, 21a) et que dans la zone du refroidisseur (21, 21a) il y a plusieurs pièces de connexion (13), qui sont enrobées d'un matériau (26, 27), isolant électrique mais aussi conducteur de la chaleur et faisant écran vis-à-vis des oscillations HF, il est relié par une surface au refroidisseur (21, 21a) pour éliminer la chaleur du composant de puissance au moins présent (12, 12a) via le refroidisseur (21, 21a) jusqu'aux pièces de connexion 13, et de là vers l'extérieur.

2. Contacteur selon la revendication 1, caractérisé en ce que plusieurs composants de puissance (12, 12a) sont disposés sur le refroidisseur (21).

3. Contacteur selon l'une des revendications précédentes, caractérisé en ce qu'au moins un composant de puissance (12a) est fixé sur le refroidisseur (21) en isolement électrique et en conduction thermique.

4. Contacteur selon l'une des revendications précédentes, caractérisé en ce qu'entre deux pièces contiguës (13) de connexion, on dispose un corps isolant électrique (26, 27), également conducteur thermique et blindage anti-HF.

5. Contacteur selon la revendication 4, caractérisé en ce que le corps (26, 27) est constitué de matière plastique chargée de ferrite ou bien est constitué d'une céramique oxyde métallique.

6. Contacteur selon l'une des revendications précédentes, caractérisé en ce que le refroidisseur (21, 21a) est relié aux pièces de connexion (13) par un film mince isolant (24) et une pâte conductrice thermiquement.

7. Contacteur selon la revendication 6, caractérisé en ce que le film isolant (24) est constitué d'une céramique d'oxyde métallique ou bien d'une matière plastique chargée de ferrite.

8. Contacteur selon l'une des revendications précédentes, caractérisé en ce que le refroidisseur (21, 21a) enrobe en partie les pièces de connexion (13) pour réaliser le blindage anti-HF.

**Claims**

1. Electrical switching device (10) having at least one power component (12, 12a) arranged in a fully insulated housing (14), a heat sink (21, 21a) for conducting away heat and having connecting parts (13) led out of the housing (14) and electrically insulated from one another, characterized in that, at least one power component (12, 12a) is arranged on the heat sink (21, 21a) and that, in the region of the heat sink (21, 21a) a plurality of connecting parts (13) is surrounded by an HF shielding and simultaneously thermally conducting, electrically insulating material (26, 27) to which the heat sink (21, 21a) is connected over a surface area in order to conduct away the heat of at least one power component (12, 12a) via the heat sink (21, 21a) to the connecting parts 13 and from there to the outside.

2. Switching device according to Claim 1, characterized in that, on the heat sink 21, a plurality of power components (12, 12a) is arranged.

3. Switching device according to one of the previous claims, characterized in that, at least power component (12a), is secured on the heat sink (21) in an electrically insulated and thermally conducting manner.

4. Switching device according to one of the previous claims, characterized in that, between adjacent connecting parts (13), an HF shielding and thermally conductive, electrically insulating body (26, 27) is arranged.

5. Switching device according to Claim 4, characterized in that the body of (26, 27) consists of a plastic filled with ferrite or of a metal oxide ceramic.

6. Switching device according to one of the previous claims, characterized in that the heat sink (21, 21a) is connected via a thin insulating film (24) and a heat conducting paste to the connecting parts (13).

7. Switching device according to Claim 6, characterized in that the insulating film (24) consists of a metal oxide ceramic or of a plastic filled with ferrite.

8. Switching device according to one of the previous claims, characterized in that the heat sink (21, 21a), for the purpose of HF shielding, partly encloses the connecting parts (13).

FIG. 1

## FIG. 2

## FIG. 3

## FIG. 4